# EUROPEAN PATENT APPLICATION

(11) **EP 1 209 736 A2**
(43) Date of publication of application: **29.05.2002**
(21) Application number: 01127267.1
(22) Date of filing: 16.11.2001
(51) Int. Cl.: H01L 21/60, H01L 23/495

(54) **Semiconductor device and method of fabricating semiconductor device**

(30) Priority: 17.11.2000 JP 2000350780
(71) Applicant: SONY CORPORATION, Tokyo (JP)
(72) Inventor: Yoshida, Koji, Kisarazu-shi, Chiba-ken (JP)
(74) Representative: Müller - Hoffmann & Partner

(57) **Abstract**

A semiconductor device includes a wiring pattern formed on a board, and a semiconductor chip bonded to the wiring pattern by ultrasonic welding. The wiring pattern is formed such that when the semiconductor chip is disposed on the wiring pattern, a range shared between the wiring pattern and positional variation regions of portions to be bonded of the semiconductor chip accompanied by the ultrasonic welding becomes as wide as possible. Such a semiconductor device makes it possible to ensure a sufficient positional deviation range of a wiring pattern with respect to a positional deviation in each bump type electrode, and hence to cope with a multipin structure for flip-chip mounting and to improve both an initial bonding characteristic and a mounting reliability.

## Description

### BACKGROUND OF THE INVENTION

The present invention relates to a semiconductor device configured such that a semiconductor chip is bonded on a wiring pattern formed on a board and a method of fabricating the semiconductor device, and particularly to the semiconductor device configured such that the bonding of the semiconductor chip is performed by ultrasonic welding and the method of fabricating the semiconductor device.

Along with the recent trend toward miniaturization and thinning of various electronic parts, semiconductor chips of a flip chip type have been used for semiconductor packages. A flip chip is a bare chip configured such that input/output terminals of a device are collected on one surface of the device and thereby the input/output connection of the device can be performed without wire bonding using gold wires or the like. The flip chip thus makes it possible to make the package thin because of eliminating the need of formation of loop shapes of gold wires or the like at the time of input/output connection of the device, and also to reduce a production time and a production cost because of reducing the step required for wire bonding.

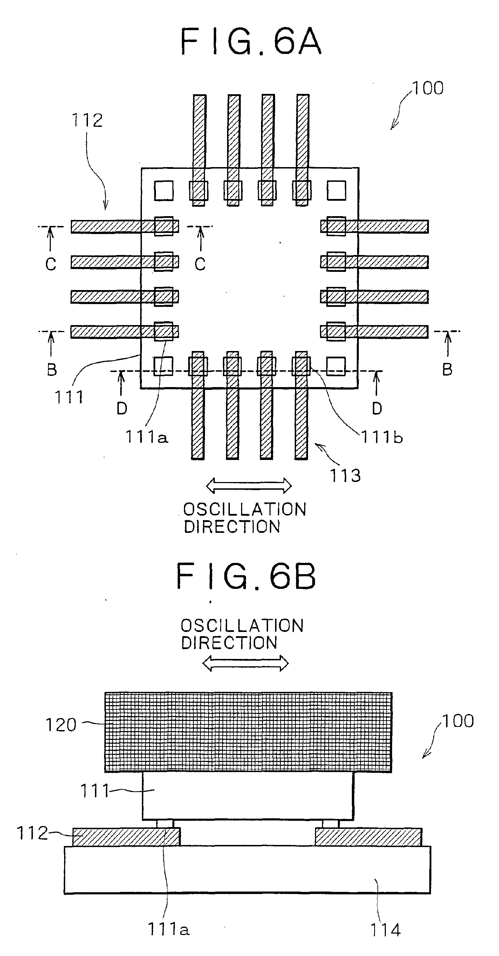

FIGS. 6A and 6B are structural views showing a configuration of a related art semiconductor device 100 using a semiconductor chip 111 of a flip chip type, wherein FIG. 6A is a plan view in through-vision of the semiconductor device 100 and FIG. 6B is a sectional view taken on line B-B of FIG. 6A.

As shown in FIGS. 6A and 6B, the semiconductor device 100 is configured such that a wiring pattern having oscillation direction side wiring pattern portions 112 and oscillation direction normal line side wiring pattern portions 113 is formed on a board 114, and the flip chip type semiconductor chip 111, on the back surface of which bump type electrodes 111a and 111b functioning as input/output terminals are provided, is mounted on the board 114. The mounting of the semiconductor chip 111 on the board 114 is, as shown in FIG. 6B, performed by ultrasonic welding using an ultrasonic head 120. The ultrasonic head 120 oscillates the semiconductor chip 111 in an oscillation direction shown in FIGS. 6A and 6B while applying a load to the semiconductor chip 111, to mechanically, electrically connect the bump type electrodes 111a and 111b to the wiring pattern by friction heat.

The connection of the bump type electrodes 111a and 111b to the wiring pattern by ultrasonic welding using the ultrasonic head 120, however, has a problem that a positional deviation allowable range of the bump type electrodes 111b with respect to the oscillation direction normal line side wiring pattern portions 113 extending in the normal line direction to the oscillation direction is small.

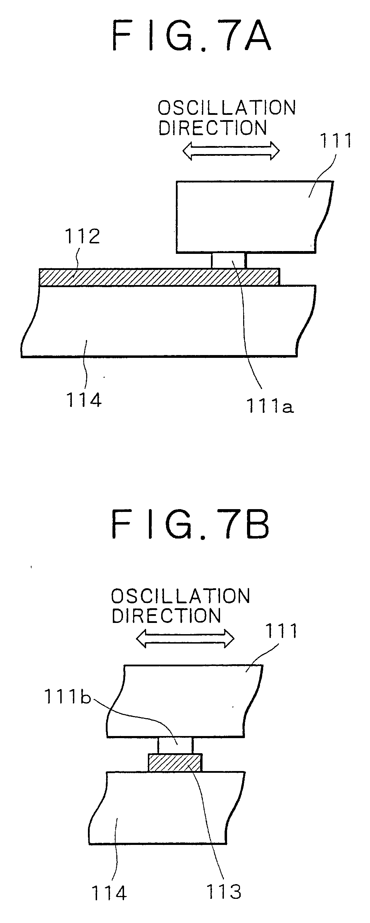

FIG. 7A is a sectional view, taken on line C-C of FIG. 6A, showing the semiconductor device 100, and FIG. 7B is a sectional view taken on line D-D of FIG. 7A.

As shown in FIG. 7A, when the semiconductor chip 111 is oscillated in the oscillation direction by the ultrasonic head 120, each bump type electrode 111a placed on the corresponding oscillation direction side wiring pattern portion 112 is oscillated in the oscillation direction while being slid on the wiring pattern portion 112 extending in the oscillation direction. Accordingly, the oscillation direction side wiring pattern portion 112 has a sufficient positional deviation allowable range with respect to a positional deviation in the bump type electrode 111a caused by the oscillation.

On the other hand, as shown in FIG. 7B, when the semiconductor device 111 is oscillated, each bump type electrode 111b placed on the corresponding oscillation direction normal line side wiring pattern portion 113 is oscillated in the oscillation direction, that is, in the direction crossing the oscillation direction normal line side wiring pattern portion 113 while being slid on the oscillation direction normal line side wiring pattern portion 113 extending in the normal line direction to the oscillation direction. Accordingly, a positional deviation allowable range of the oscillation direction normal line side wiring pattern portion 113 with respect to a positional deviation in the bump type electrode 111b is limited to a lateral width of the oscillation direction normal line side wiring pattern portion 113, and therefore, it is impossible to ensure a sufficient positional deviation in the oscillation direction normal line side wiring pattern portion 113 with respect to a positional deviation in the bump type electrode 111b. As a result, the above-described configuration of the related art semiconductor device 111 presents a problem that it does not cope with a multi-pin structure for flip-chip mounting, and fails to improve both an initial bonding characteristic and a mounting reliability.

### SUMMARY OF THE INVENTION

An object of the present invention is to provide a semiconductor device capable of ensuring, in the case of bonding bump type electrodes to a wiring pattern by ultrasonic welding, a sufficient positional deviation range of the wiring pattern with respect to a positional deviation in each bump type electrode, thereby coping with a multi-pin structure for flip-chip mounting and improving both an initial bonding characteristic and a mounting reliability, and to provide a method of fabricating the semiconductor device.

To achieve the above object, according to a first aspect of the present invention, there is provided a semiconductor device including: a wiring pattern formed on a board; and a semiconductor chip bonded to the wiring pattern by ultrasonic welding; wherein at least part of the wiring pattern is arrayed in such a manner as to be inclined at a specific angle with respect to a normal line to an oscillation direction of the semiconductor chip oscillated by the ultrasonic welding.

With this configuration, the wiring pattern is formed such that when the semiconductor chip is disposed on the wiring pattern, a range shared between the wiring pattern and positional variation regions of portions to be bonded of the semiconductor chip accompanied by the ultrasonic welding becomes as wide as possible, and accordingly, in the case of bonding bump type electrodes of the semiconductor chip by using an ultrasonic head, it is possible to ensure a sufficient positional deviation allowable range of the wiring pattern with respect to a positional deviation in each bump type electrode.

In the semiconductor device of the present invention, the semiconductor chip is preferably a flip chip.

According to a second aspect of the present invention, there is provided a method of fabricating a semiconductor device, including the step of: bonding a semiconductor chip on a wiring pattern formed on a board by ultrasonic welding; wherein at least part of the wiring pattern is arrayed in such a manner as to be inclined at a specific angle with respect to a normal line to an oscillation direction of the semiconductor chip oscillated by the ultrasonic welding.

With this configuration, the wiring pattern is formed such that when the semiconductor chip is disposed on the wiring pattern, a range shared between the wiring pattern and positional variation regions of portions to be bonded of the semiconductor chip accompanied by the ultrasonic welding becomes as wide as possible, and accordingly, in the case of bonding bump type electrodes of the semiconductor chip by using an ultrasonic head, it is possible to ensure a sufficient positional deviation allowable range of the wiring pattern with respect to a positional deviation in each bump type electrode.

In the method of fabricating a semiconductor device according to the present invention, the semiconductor chip is preferably a flip chip.

### BRIEF DESCRIPTION OF THE DRAWINGS

The above and other features and advantages of the present invention will become apparent from the following description taken in conjunction with the accompanying drawings, in which:
FIGS. 1A and 1B are structural views showing a configuration of a semiconductor device, wherein FIG. 1A is a plan view in through-vision of the semiconductor device, and FIG. 1B is a sectional view taken on line A-A of FIG. 1A;

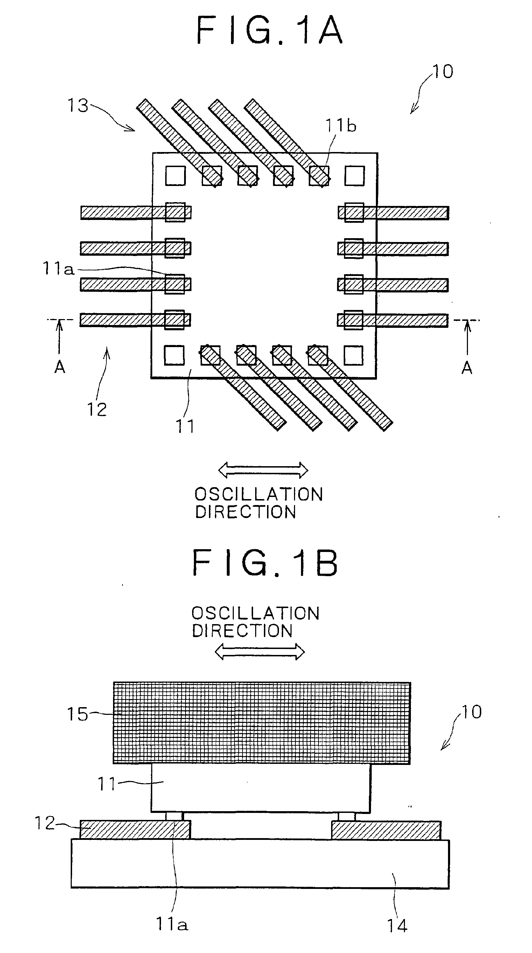

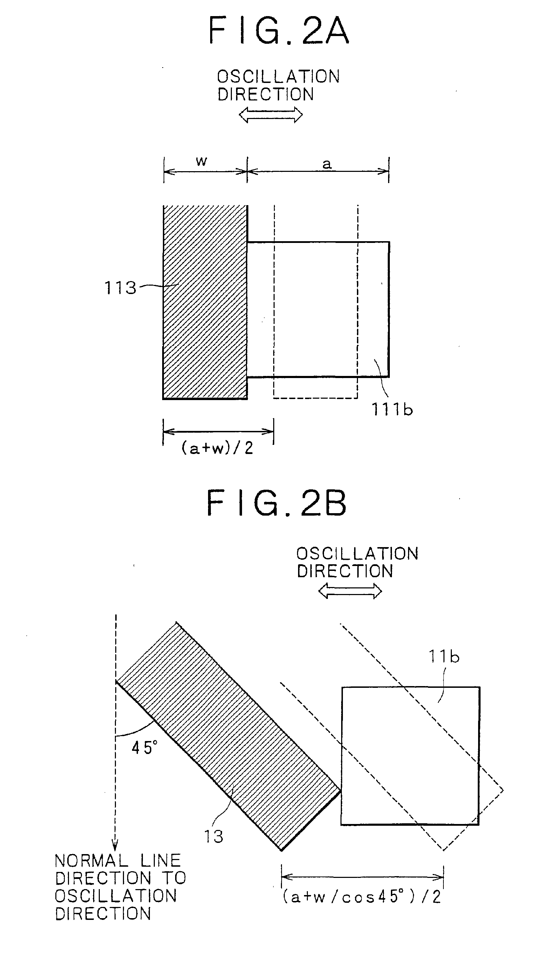

FIGS. 2A and 2B are views comparatively illustrating a positional deviation allowable range of each oscillation direction normal line side wiring pattern portion in the case of oscillating a semiconductor chip in an oscillation direction by an ultrasonic head, wherein FIG. 2A shows a positional deviation allowable range of each oscillation direction normal line side wiring pattern portion of a related art semiconductor device, and FIG. 2B shows a positional deviation allowable range of each oscillation direction normal line side wiring pattern portion of the semiconductor device of the present invention shown in FIGS. 1A and 1B;
FIG. 3 is a plan view, in through-vision, showing a configuration of the semiconductor device of the present invention;
FIG. 4 is a plan view, in through-vision, showing another configuration of the semiconductor device of the present invention;
FIG. 5 is a plan view, in through-vision, showing a further configuration of the semiconductor device of the present invention;
FIGS. 6A and 6B are structural views showing a configuration of a related art semiconductor device, wherein FIG. 6A is a plan view in through-vision of the semiconductor device, and FIG. 6B is a sectional view taken on line B-B of FIG. 6A; and
FIGS. 7A and 7B are sectional views of the semiconductor device shown in FIG. 6A, wherein FIG. 7A is the sectional view taken on line C-C of FIG. 6A and FIG. 7B is the sectional view taken on line D-D of FIG. 6A.

### DETAILED DESCRIPTION OF THE PREFERRED EMBODIMENTS

Hereinafter, preferred embodiments of the present invention will be described with reference to the accompanying drawings.

A first embodiment of the present invention will be described below.

FIGS. 1A and 1B are structural views showing a configuration of a semiconductor 10 according to this embodiment, wherein FIG. 1A is a plan view in through-vision of the semiconductor device 10, and FIG. 1B is a sectional view taken on line A-A of FIG. 1A.

The semiconductor device 10 is configured such that a semiconductor chip 11 of a flip chip type is mounted on a board 14. The semiconductor chip 11 has bump type electrodes 11a and 11b as portions to be bonded. On the other hand, a wiring pattern composed of oscillation direction side wiring pattern portions 12 and oscillation direction normal line side wiring pattern portions 13 is previously formed on the board 14. The bump type electrodes 11a and 11b of the semiconductor chip 11 are conductively connected to the wiring pattern portions 12 and 13 of the wiring pattern by ultrasonic welding using an ultrasonic head 15, respectively.

The bump type electrodes 11a and 11b are each made from, for example, a conductive metal material or a resin material containing a metal powder, and formed into shapes of bumps on one surface of the semiconductor chip 11.

The board 14 is made from a material mainly containing, for example, a ceramic material or an epoxy resin, and may be configured as either of a single layer board, a double layer board, and a multi-layer board.

The wiring pattern, which is composed of the oscillation direction side wiring pattern portions 12 and the oscillation direction normal line side wiring pattern portions 13, may be made from any material such as electrolytic gold, electroless gold, copper, or tungsten insofar as it has an electrical conductivity and is generally used for pattern formation.

The oscillation direction side wiring pattern portions 12 are formed in such a manner as to extend in the oscillation direction of the ultrasonic head 15, and the oscillation direction normal line side wiring pattern portions 13 are formed in such a manner as to be inclined at a specific angle with respect to the normal line to the oscillation direction of the ultrasonic head 15. The specific angle may be desirable to be as large as possible with respect to the normal line to the oscillation direction of the ultrasonic head 15. The specific angle may be also desirable to be set such that the oscillation direction normal line side wiring pattern portion 13, which is placed on one of the bump type electrodes 11b, is not in contact with another bump type electrode 11b adjacent to that on which the above wiring pattern portion 13 is placed.

Any one of the oscillation direction normal line side wiring pattern portions 13 may be desirable not to be approximately perpendicular to the oscillation direction of the semiconductor chip 11 oscillated by ultrasonic welding. In the example of the first embodiment shown in FIG. 1A, the oscillation direction normal line side wiring pattern portions 13 located on the lower side of the figure are inclined in the rightward.direction at about 45° with respect to the normal line to the oscillation direction, while the oscillation direction normal line side wiring pattern portions 13 located on the upper side of the figure are inclined in the leftward direction at about 45° with respect to the normal line to the oscillation direction.

With such a configuration that the oscillation direction normal line side wiring pattern portions 13 are inclined at a specific angle with respect to the normal line to the oscillation direction of the ultrasonic head 15, the wiring pattern can be formed such that when the semiconductor chip 11 is disposed on the wiring pattern, a range shared between each oscillation direction normal line side wiring pattern 13 and a positional variation region of the corresponding bump type electrode 11b of the semiconductor chip 11 accompanied by ultrasonic welding becomes as wide as possible.

FIGS. 2A and 2B are views comparatively illustrating a positional deviation allowable range of each oscillation direction normal line side wiring pattern portion in the case of oscillating the semiconductor chip 11 in the oscillation direction by the ultrasonic head 15, wherein FIG. 2A shows a positional deviation allowable range of each oscillation direction normal line side wiring pattern portion 113 of the related art semiconductor device 100 shown in FIGS. 6A and 6B, and FIG. 2B shows a positional deviation allowable range of each oscillation direction normal line side wiring pattern portion 13 of the semiconductor device 10 of the present invention shown in FIGS. 1A and 1B.

Referring to FIG. 2A, letting "a" be a width of the bump type electrode 111b and "w" be a width of the oscillation direction normal line side wiring pattern portion 113, a positional deviation allowable range of the oscillation direction normal line side wiring pattern portion 113 of the semiconductor device 100 shown in FIGS. 6A and 6B, that is, a range in which the bump type electrode 111b is disconnected from the oscillation direction normal line side wiring pattern portion 113 even if a position of the oscillation direction normal line side wiring pattern portion 113 is deviated, is given by an expression of (a + w)/2.

On the contrary, as shown in FIG. 2B, according to the semiconductor device 10 of the present invention in which the oscillation direction normal line side wiring pattern portion 13 is inclined at about 45° with respect to the normal line to the oscillation direction, a positional deviation allowable range of the oscillation direction normal line side wiring pattern portion 13 of the semiconductor device 10 is given by an expression of (a + w/cos45°)/2. As a result, according to the semiconductor device 10 of the present invention, it is possible to ensure a sufficient positional deviation allowable range as compared with the related art configuration.

In this way, according to this embodiment, the oscillation direction normal line side wiring pattern portions 13 are inclined at a specific angle with respect to the normal line to the oscillation direction of the ultrasonic head 15, and the wiring pattern is formed such that when the semiconductor chip 11 is disposed on the wiring pattern, a range shared between each oscillation direction normal line side wiring pattern 13 and a positional variation region of the corresponding bump type electrode 11b of the semiconductor chip 11 accompanied by ultrasonic welding becomes as wide as possible. Accordingly, it is possible to ensure, in the case of bonding the bump type electrodes lib to the oscillation direction normal line side wiring pattern portions 13 by ultrasonic welding, a sufficient positional deviation allowable range of the oscillation direction normal line side wiring pattern portions 13 with respect to positional deviations in the bump type electrodes 11b, and hence to cope with a multi-pin structure for flip-chip mounting and improve both an initial bonding characteristic and a mounting reliability.

A second embodiment of the present invention will be described below.

This embodiment is a modification of the first embodiment, and is different from the first embodiment only in a configuration of oscillation direction normal line side wiring pattern portions. In the following, only the difference between this embodiment and the first embodiment will be mainly described, with the overlapped description of the parts common to those in the first embodiment being omitted.

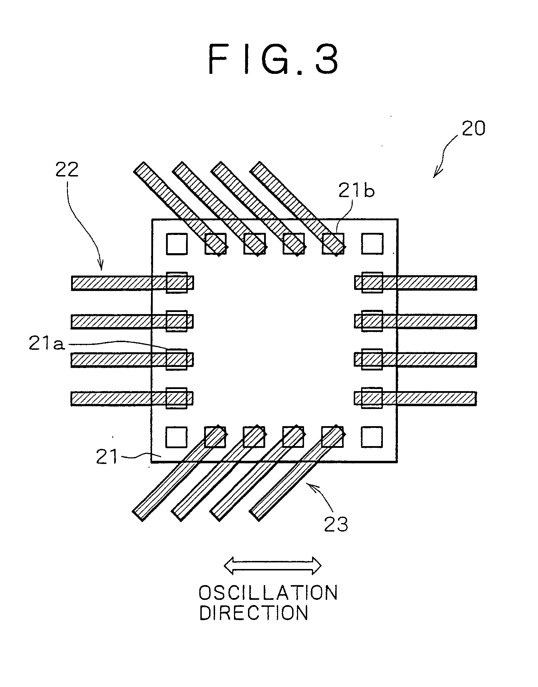

FIG. 3 is a plan view, in through-vision, showing a configuration of a semiconductor device 20 according to this embodiment.

The semiconductor device 20 is configured, like the first embodiment, such that a semiconductor chip 21 of a flip chip type is mounted on a board. The semiconductor chip 21 has bump type electrodes 21a and 21b as portions to be bonded. On the other hand, a wiring pattern composed of oscillation direction side wiring pattern portions 22 and oscillation direction normal line side wiring pattern portions 23 is previously formed on the board. The bump type electrodes 21a and 21b of the semiconductor chip 21 are connected to the wiring pattern portions 22 and 23 of the wiring pattern by ultrasonic welding, respectively.

In the semiconductor device according to the first embodiment, the oscillation direction normal line side wiring pattern portions located on the lower side of the figure are inclined in the rightward direction and the oscillation direction normal line side wiring pattern portions located on the upper side of the figure are inclined in the leftward direction; however, in the semiconductor device 20 according to this embodiment, as shown in FIG. 3, the oscillation direction normal line side wiring pattern portions 23 located on the lower side of the figure are inclined in the leftward direction and the oscillation direction normal line side wiring pattern portions 23 located on the upper side of the figure are also inclined in the leftward direction.

The difference between this embodiment and the first embodiment lies only in the above-described point, and the same effect as that obtained by the first embodiment can be also obtained by this embodiment in which the oscillation direction normal line side wiring pattern portions 23 are configured as described above.

In this way, according to this embodiment, the oscillation direction normal line side wiring pattern portions 23 are inclined at a specific angle with respect to the normal line to the oscillation direction, and the wiring pattern is formed such that when the semiconductor chip 21 is disposed on the wiring pattern, a range shared between each oscillation direction normal line side wiring pattern 23 and a positional variation region of the corresponding bump type electrode 21b of the semiconductor chip 21 accompanied by ultrasonic welding becomes as wide as possible. Accordingly, it is possible to ensure, in the case of bonding the bump type electrodes 21b to the oscillation direction normal line side wiring pattern portions 23 by ultrasonic welding, a sufficient positional deviation allowable range of the oscillation direction normal line side wiring pattern portions 23 with respect to positional deviations in the bump type electrodes 21b, and hence to cope with a multi-pin structure for flip-chip mounting and improve both an initial bonding characteristic and a mounting reliability.

A third embodiment of the present invention will be described below.

This embodiment is another modification of the first embodiment, and is different from the first embodiment only in a configuration of oscillation direction normal line side wiring pattern portions. In the following, only the difference between this embodiment and the first embodiment will be mainly described, with the overlapped description of the parts common to those in the first embodiment being omitted.

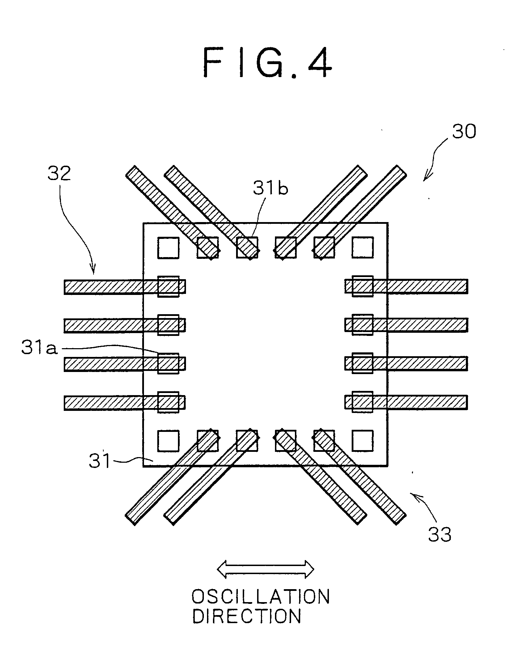

FIG. 4 is a plan view, in through-vision, showing a configuration of a semiconductor device 30 according to this embodiment.

The semiconductor device 30 is configured, like the first embodiment, such that a semiconductor chip 31 of a flip chip type is mounted on a board. The semiconductor chip 31 has bump type electrodes 31a and 31b as portions to be bonded. On the other hand, a wiring pattern composed of oscillation direction side wiring pattern portions 32 and oscillation direction normal line side wiring pattern portions 33 is previously formed on the board. The bump type electrodes 31a and 31b of the semiconductor chip 31 are connected to the wiring pattern portions 32 and 33 of the wiring pattern by ultrasonic welding, respectively.

As shown in FIG. 4, in the semiconductor device 30 according to this embodiment, of the oscillation direction normal line side wiring pattern portions 33 located on the lower side of the figure, two on the left end side are inclined in the leftward direction and two on the right end side are inclined on the rightward direction, and of the oscillation direction normal line side wiring pattern portions 33 located on the upper side of the figure, two on the left end side are inclined in the leftward direction and two on the right end side are inclined in the rightward direction.

The difference between this embodiment and the first embodiment lies only in the above-described point, and the same effect as that obtained by the first embodiment can be also obtained by this embodiment in which the oscillation direction normal line side wiring pattern portions 33 are configured as described above.

In this way, according to this embodiment, the oscillation direction normal line side wiring pattern portions 33 are inclined at a specific angle with respect to the normal line to the oscillation direction, and the wiring pattern is formed such that when the semiconductor chip 31 is disposed on the wiring pattern, a range shared between each oscillation direction normal line side wiring pattern 33 and a positional variation region of the corresponding bump type electrode 31b of the semiconductor chip 31 accompanied by ultrasonic welding becomes as wide as possible. Accordingly, it is possible to ensure, in the case of bonding the bump type electrodes 31b to the oscillation direction normal line side wiring pattern portions 33 by ultrasonic welding, a sufficient positional deviation allowable range of the oscillation direction normal line side wiring pattern portions 33 with respect to positional deviations in the bump type electrodes 31b, and hence to cope with a multi-pin structure for flip-chip mounting and improve both an initial bonding characteristic and a mounting reliability.

A fourth embodiment of the present invention will be described below.

This embodiment is a further modification of the first embodiment, and is different from the first embodiment in configurations of oscillation direction side wiring pattern portions and oscillation direction normal line side wiring pattern portions. In the following, only the difference between this embodiment and the first embodiment will be mainly described, with the overlapped description of the parts common to those in the first embodiment being omitted.

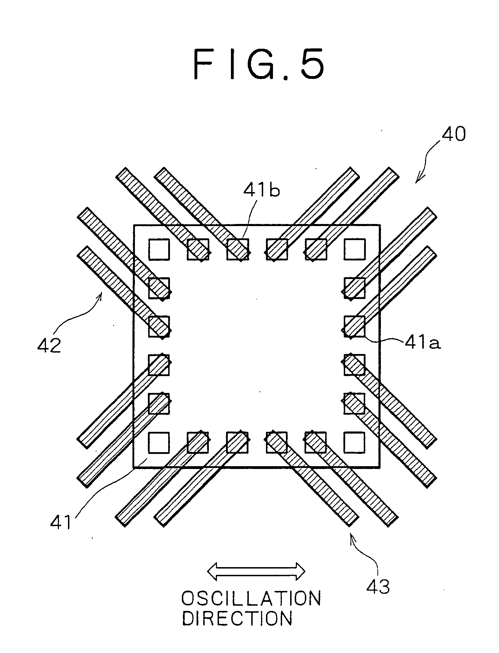

FIG. 5 is a plan view, in through-vision, showing a configuration of a semiconductor device 40 according to this embodiment.

The semiconductor device 40 is configured, like the first embodiment, such that a semiconductor chip 41 of a flip chip type is mounted on a board. The semiconductor chip 41 has bump type electrodes 41a and 41b as portions to be bonded. On the other hand, a wiring pattern composed of oscillation direction side wiring pattern portions 42 and oscillation direction normal line side wiring pattern portions 43 is previously formed on the board. The bump type electrodes 41a and 41b of the semiconductor chip 41 are connected to the wiring pattern portions 42 and 43 of the wiring pattern by ultrasonic welding, respectively.

As shown in FIG. 5, in the semiconductor device 40 according to this embodiment, of the oscillation direction normal line side wiring pattern portions 43 located on the lower side of the figure, two on the left end side are inclined in the leftward direction and two on the right end side are inclined on the rightward direction, and of the oscillation direction normal line side wiring pattern portions 43 located on the upper side of the figure, two on the left end side are inclined in the leftward direction and two on the right end side are inclined in the rightward direction.

Further, of the oscillation direction side wiring pattern portions 42 located on the left side of the figure, two on the upper end side are inclined in the upward direction and two on the lower end side are inclined in the downward direction, and of the oscillation direction side wiring pattern portions 42 located on the right side of the figure, two on the upper end side are inclined in the upward direction and two on the lower end side are inclined in the downward direction.

The difference between this embodiment and the first embodiment lies only in the above-described point, and the same effect as that obtained by the first embodiment can be also obtained by this embodiment in which the oscillation direction side wiring pattern portions 42 and the oscillation direction normal line side wiring pattern portions 43 are configured as described above.

In this way, according to this embodiment, the oscillation direction normal line side wiring pattern portions 43 are inclined at a specific angle with respect to the normal line to the oscillation direction, and the wiring pattern is formed such that when the semiconductor chip 41 is disposed on the wiring pattern, a range shared between each oscillation direction normal line side wiring pattern 43 and a positional variation region of the corresponding bump type electrode 41b of the semiconductor chip 41 accompanied by ultrasonic welding becomes as wide as possible. Accordingly, it is possible to ensure, in the case of bonding the bump type electrodes 41b to the oscillation direction normal line side wiring pattern portions 43 by ultrasonic welding, a sufficient positional deviation allowable range of the oscillation direction normal line side wiring pattern portions 43 with respect to positional deviations in the bump type electrodes 41b, and hence to cope with a multi-pin structure for flip-chip mounting and improve both an initial bonding characteristic and a mounting reliability.

Another advantage of this embodiment is that since the oscillation direction side wiring pattern portions 42 are also inclined, even if oscillation at the time of ultrasonic welding is performed in the vertical direction in the figure, it is possible to ensure a sufficient positional deviation allowable range of the wiring pattern.

It is to be noted that in the first, second, third and fourth embodiments, the description has been made by example of ultrasonic welding for a semiconductor chip in the process of fabricating a semiconductor device; however, the present invention is not limited thereto but may be applied to ultrasonic welding for any other device such as an SAW filter using a flip chip.

While the embodiments of the present invention have been described using the specific terms, such description is for illustrative purposes only, and it is to be understood that changes and variations may be made without departing from the sprit or scope of the following claims.

## Claims

1. A semiconductor device comprising:
a wiring pattern formed on a board; and
a semiconductor chip bonded to said wiring pattern by ultrasonic welding;
wherein at least part of said wiring pattern is arrayed in such a manner as to be inclined at a specific angle with respect to a normal line to an oscillation direction of said semiconductor chip oscillated by said ultrasonic welding.

2. A semiconductor device according to claim 1, wherein said semiconductor chip is a flip chip.

3. A method of fabricating a semiconductor device, comprising the step of:
bonding a semiconductor chip on a wiring pattern formed on a board by ultrasonic welding;
wherein at least part of said wiring pattern is arrayed in such a manner as to be inclined at a specific angle with respect to a normal line to an oscillation direction of said semiconductor chip oscillated by said ultrasonic welding.

4. A method of fabricating a semiconductor device according to claim 3, wherein said semiconductor chip is a flip chip.
